(19)

Europäisches
Patentamt
European
Patent Office
Office européen
des brevets

(11) **EP 1 786 236 B1**

(12) **EUROPEAN PATENT SPECIFICATION**

(45) Date of publication and mention
of the grant of the patent:
**02.09.2009 Bulletin 2009/36**

(51) Int Cl.:
***H04R 3/00*** *(2006.01)*

(21) Application number: **05024416.9**

(22) Date of filing: **09.11.2005**

(54) **Complementary-pair equalizer**

Paarweise komplementärer Entzerrer

Égalisateur complémentaires en paires

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**16.05.2007 Bulletin 2007/20**

(73) Proprietor: **Schwartz, Stephen R.**
**Providence, RI 02906 (US)**

(72) Inventors:
• **Schwartz, Stephen R.**
**Providence, RI 02906 (US)**
• **Osmand, John H.**
**Providence,**
**Rhose Island 02906 (US)**
• **Kulash, Damian**
**Los Angeles, CA 90004 (US)**

(74) Representative: **Vossius & Partner**
**Siebertstraße 4**
**81675 München (DE)**

(56) References cited:
**EP-A- 1 251 714          DE-A1- 4 436 272**
**US-A- 5 748 754**

## Description

The present invention deals with the field of signal modification. In particular, it deals with a method and device/s for the selection of frequency portions of at least two versions of a signal which are summed to create a signal which may be superior to, and/or avoid problems found in,one or more of the source signals.

When transducing audio signals to electrical signals, it is common to eliminate undesireable elements by the process of somehow filtering or equalizing those signals. For example, where a musical performance is recorded in a concert hall, problem noises are often caused by the noises made by lights, HVAC systems and blowers, etc. Some of these sounds may be more pronounced at some places than at others. It is common for there to be certain places where the overall sound is most desireable, even though such places may have specific problems, such as a particular buzz caused by a nearby light fixture. When a placement still seems optimum despite a problem, the common solution is to use a filter/equalizer to reduce the frequency band of the offending sound. The filter reduces all signal in the given frequency band, both the offending sound and the desired portions of the signal. In the circumstance where there is no desired signal in the given frequency band, this is not a problem. An example is when there is an undesireable high-pitched hiss as commonly given off by a steam radiator, and a person at a podium talking into a microphone. There is a good chance that there is little energy from the person that is in the frequency range of the hiss, so reducing that range drastically to reduce the offending hiss will not degrade the intelligiblity of the person.

However, if the steam radiator is sharing the room with a group of musical instruments, such as a chamber orchestra, certain elements of the music will be affected. Higher notes or instruments (such as flutes) may be affected more than others, thus changing the balance of notes and instruments from what the composer intended and the performers practiced. A sound engineer will seek to affect the musical sound as little as possible while eliminating the offending sound as much as possible. The typical result is a compromise where there is more of the offensive sound than desired, the music does not sound as good as it could, or both.

Document US-A-5,748,754 relates to a sound system and gain and equalization circuit.

The solutions presented below may be tangentially related to certain aspects of a speaker crossover network, a common device in the audio field. Loudspeaker systems are made of separate speaker elements, such as woofers (low frequency drivers), tweeters (high frequency drivers), and midrange drivers. Each element is optimized for a specific and limited frequency band, and requires the absence of frequencies not in its limited frequency band. A common speaker crossover divides an incoming signal into 2 or more frequency bands for distribution to separate speaker elements.

According to an embodiment of the present invention, filters/equalizers/etc. are constructed to include a second signal path, whose frequency response is essentially the inverse of the original signal path. This second signal path is coupled with a second source of the signal, which is chosen only for its quality in the frequency band/s reduced in the first signal path. The first filtered signal and second 'inverse-filtered' signal are then summed, which may result in a signal similar in accuracy to the first signal path alone, and may also have an increase in the rejection of the undesired signal. In general, the two source signals are assumed to be of similar intensity within the pertinent frequency band/s, though compensation can likely be made when they are not.

In the example of the steam radiator and chamber orchestra above, a second signal may be supplied by a second microphone placed far from the offending steam sound. This may be in an odd corner of the room, which may not be good for the overall sound of the music - this second spot needs only to have an increase in ratio of desired sound (music) to undesired sound (steam hiss) in the frequency range of the undesired sound, as compared to the first signal in the same frequency range. As the apparatus is adjusted to decrease the energy of the original signal's offending frequency band, where the amount of unwanted noise is high, it simultaneously increases the energy in the same band of the second signal, where the amount of unwanted noise is low. The summing of the signals will provide an increase in the reduction of the unwanted noise, while maintaining the fidelity of the original music.

FIG. 1 is a general block diagram of a typical prior art audio equalizer.

FIG. 2A is a general block diagram of an audio equalizer arranged for the addition of inverse filter elements, according to an embodiment of the present invention.

FIG. 2B is FIG. 2A, with an additional set of controls added to the secondary channel.

FIG. 3A is a general block diagram of a typical prior art multi-band audio equalizer, similar to FIG. 1, but with multiple bands.

FIG. 3B is a general block diagram of the device of FIG. 3A, adapted for the addition of inverse filter elements, according to an embodiment of the present invention.

FIG. 3C is a general block diagram of a second multiple band version of an audio equalizer arranged for the addition of inverse filter elements, according to an embodiment of the present invention.

FIG. 3D is a general block diagram of a third multiple band version of an audio equalizer arranged for the addition of inverse filter elements, according to an embodiment of the present invention.

FIG. 4 is a general block diagram of an embodiment with a switching arrangement which allows a user to choose one of the embodiments of FIGS: 3A, 3B, 3C, and 3D from within a single device.

FIG. 5 is a schematic diagram of an embodiment of the present invention designed specifically for use with two microphones, and optimized to reduce the acoustic crosstalk from a hi-hat in a signal from a snare drum.

FIG. 6 is a first simplified version of filter portion 52 of the embodiment in FIG. 5.

FIG. 7 is a second simplified version of filter portion 52 of the embodiment in FIG. 5.

FIG. 8 is FIG. 2A, arranged for use as a frequency emphasis/de-emphasis device.

FIG. 9 is a schematic diagram of an embodiment of the present invention designed to perform simultaneous bandpass and band-reject of a pair of signals

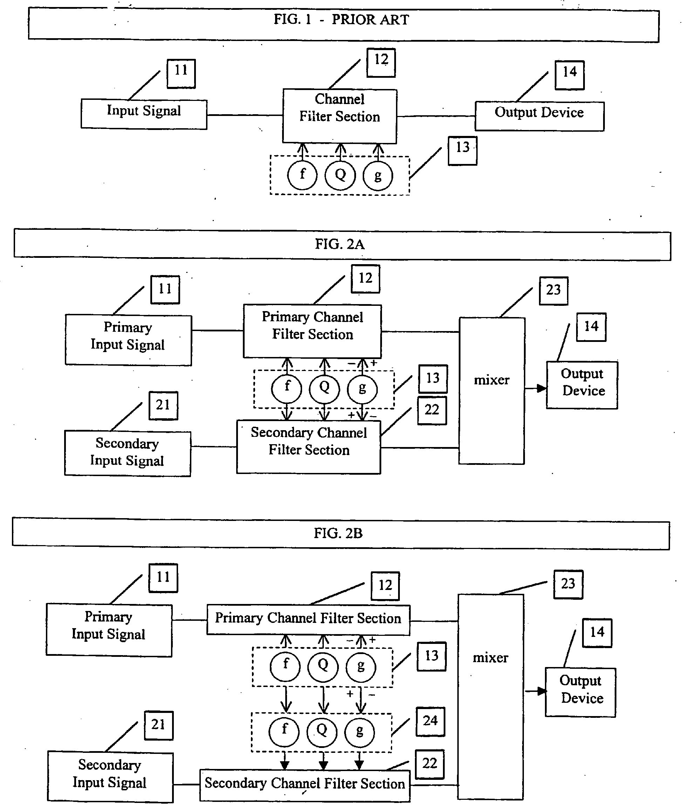

FIG. 1 is a general block diagram of a typical audio equalizer as is known in the art. The type shown here is for a single channel of a fully-parametric equalizer. An input signal 11 is fed to a filter circuit 12 whose parameters are determined by the controls 'f', 'Q' and 'g' 13. Control 'f' determines the center frequency of the affected area. Control 'Q' determines the bandwidth of the affected area. Control 'g' reduces (by convention, counterclockwise from center position) or increases (clockwise from center position) the signal in the area determined by the settings of 'f' and 'Q'. At the center setting of 'g', where there is no increase or decrease of signal, the settings of 'f' and 'Q' have no effect. The final signal may be sent to an output device 14. For some discussion below, it is helpful to refer to input signal 11 and filter circuit 12 as the PRIMARY input signal and filter circuit.

There are two basic categories of filters. The first category is that of the simple filter shapes known as highpass, lowpass, bandpass, and notch(i.e., band reject). When these are added to the original signal, an eq (equalizer) type filter is created.

FIG. 2A is a general block diagram of an audio equalizer arranged for the addition of a complementary pair of inverse filter elements, according to an embodiment of the present invention. In this example, both filter elements 12 and 22 may be of the eq type. A second input signal 21 is fed to a second filter circuit 22, which may be identical to filter circuit 12. We refer to input signal 21 and filter circuit 22 as the SECONDARY or alternate input signal and filter circuit. Both filter circuits, 12 and 22, are controlled by the same single set of controls 13. However, the 'g' control's effect on the secondary circuit 22 may be the opposite of its effect on the primary circuit 12. Thus, as a particular frequency region is reduced by primary circuit 12, it is also increased by secondary circuit 22 by the same magnitude. The outputs are mixed by circuit 23, which may provide control (not shown) of the relative strength of outputs 12 and 22, if desired. Due to the nature of some signals, phase inversion switches may be desireable at suitable locations for any embodiment of the present invention.

The boost gain should complement the cut gain in a proportion that maintains the overall gain relationship on the outputs of 12 and 22 when combined. With no cut or boost, the band gain is 0 dB for both channels 12 and 22, and the sum of their outputs yields a gain of +6 dB, assuming similar in-phase signals. Thus, if channel 12's frequency band is reduced to minus infinity dB, channel 22's frequency band is boosted to +6 dB to compensate for the reduction. Conversely, if channel 12 is boosted +6 dB, channel 22 is reduced to minus infinity dB.

Another embodiment, similar to the device described above, configures primary channel 12 as eq with reduction filtering only, and configures secondary channel 22 as pass-band filtering with no flat setting. With gain control 'g' set to full gain (full clockwise) at primary channel 12, response is flat 0 dB gain for filter 12 and minus infinity dB for the entire bandwidth of filter 22. The output of mixer 23 is therefore the unaltered primary channel input 11 from channel 12, rather than the sum of channels 12 and 22 as above. As the selected frequencies of 12 are decreased, the corresponding frequencies of 22 are increased to "fill the holes" made by the activity of 12. When the selected frequencies of 12 are reduced to minus infinity dB, the corresponding frequencies of 22 are at unity gain. Filter channels 12 and 22 may have an input gain trim to adjust levels to compensate for differences in the input signals 11 and 21. The channel filters may have a switch to toggle function between these two arrangements.

If the primary and secondary inputs 11 and 21 were properly chosen, the result of the embodiment will be as described. For the example of the chamber orchestra and steam radiator above, the primary input signal 11 is from the microphone in the optimum spot for the sound of the orchestra, and the secondary input signal 21 is from the microphone in an odd corner of the room that is far from the steam radiator. The operator adjusts the controls for the best compromise between the good orchestra sound and least steam noise, as follows. The following process is facilitated by having separate volume controls at mixer 23. Step 2 involves first INCREASING the level of the offending sound because it is easier for a human operator to isolate a problem area by hearing it at a loud level, then reducing it as indicated in Step 3.

1 - Turn off/down the secondary signal output, and set the controls for high gain ('g' clockwise from center) and 'Q' to about an octave.

2 - Move frequency control 'f' so that the offending noise is at its loudest.

3 - Set the gain control 'g' for strong cut (counter-clockwise from center).

4 - Adjust the 'Q' control to be as narrow as possible, without significantly increasing the noise.

5 - Fine tune frequency control 'f' for best rejection.

6 - Repeat 4 and 5 as needed until an optimum is reached for frequency center and narrowest width, also adjusting gain control 'g' for as little cut as is optimum.

7 - Add the secondary channel input to normal gain.

8 - Adjust controls for optimum results. Repeat previous steps as needed.

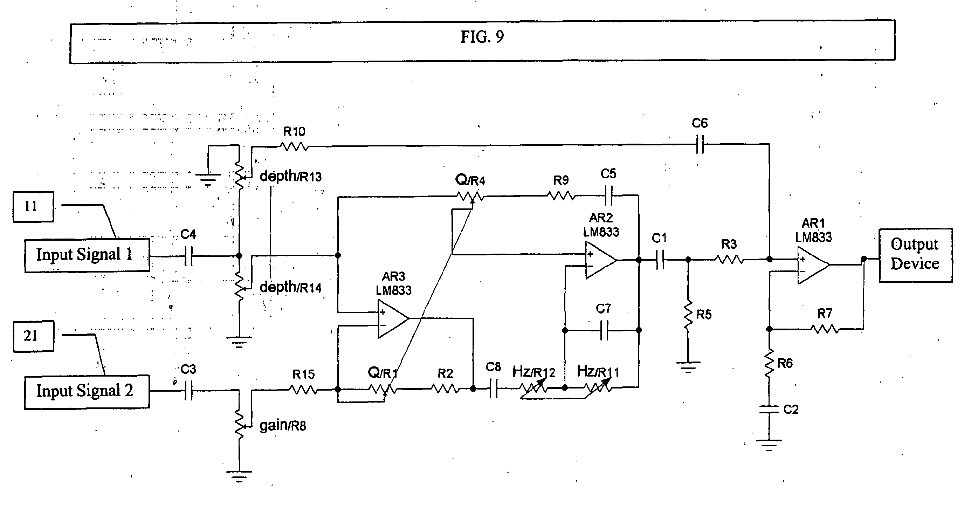

FIG. 9 shows a schematic diagram of an implementation of a single band complementary pair equalizer which makes special use of signal phase relationships to accomplish both the primary signal band-reject (notch) filter and the secondary signal bandpass filter to be accomplished by a single circuit. Amplifier AR3 inverts secondary signal 21 and mixes it with in-phase primary signal 11. This mixed signal is fed through a bandpass filter (C7,C8,R11,R12, etc.) which is inverted by the inverting input of amplifier AR2. The resultant signal at this point is the selected passband region of the inverted phase primary signal 11 and the in-phase secondary signal 21. To this mixed signal is added the original in-phase primary signal, via R4. The portion of the mixed bandpass signal, which is the inverted phase region of the primary signal, cancels with the complementary portion of the in-phase complete primary signal and results in a band-reject (notch) filter for the primary signal. The portion of the mixed bandpass filter output signal that is the in-phase region of the secondary signal remains unaffected. Thus, the single bandpass circuit (C7,C8,R11,R12, etc.) suffices to perform a band-reject function on primary signal 11 and a bandpass function on secondary signal 21.

This implementation is only one of many possible ways to accomplish the task. Another possibility is to simply combine the primary and secondary signals, pass the combined signal through the bandpass filter, and add to the filter's output the primary signal unfiltered, but 180 degrees out of phase. It is important to get the phase relationships correct, making sure that the primary bandpassed signal is added to the original primary signal, these two bearing a 180 degree phase relationship to each other.

FIG. 2B is identical to FIG. 2A, except for the addition of a 2nd set of controls 24 which affect only Secondary Channel EQ 22. Because of the complexity of some signals, the imperfection of any physical embodiments, etc., it may be advantageous to provide this set to allow the parameters of the secondary path's filters to be varied from the positions set by the primary controls 13 (widen or narrow the Q, sweep the frequency up/down, increase/reduce the gain). Operation is as described as for FIG. 2A, but would add a step at the end for fine tuning with the controls 24.

The device may be constructed with multiple bands (sections), each section operating in the same way. Prior art audio equalizers currently used for the purposes of the example above generally contain 3, 4 or 5 bands. Care must be given to the arrangement of the filter elements (re:parallel,series,etc.) so that each complementary primary/secondary pair achieves the desired result. This phenomenum is known in the art, and is dependent on the type of filter element used.

Mentioned above are two basic categories of filters. The first category is that of the simple filter shapes known as highpass, lowpass, bandpass, and notch (i.e., band reject). These may be mathematically represented by $T(s)$, where s is the complex frequency and $T(s)$ is the voltage transfer function of the complex frequency. When these are added to the original signal, an eq (equalizer) type filter is created. An equalizer can be crudely represented by $(1-T(s))$, and its complement would be $(1+T(s))$. For audio purposes in general, a group of simple filters usually works best arranged in parallel (where transfer functions are added), and a group of eq type filters works best arranged in series (where transfer functions are multiplied).

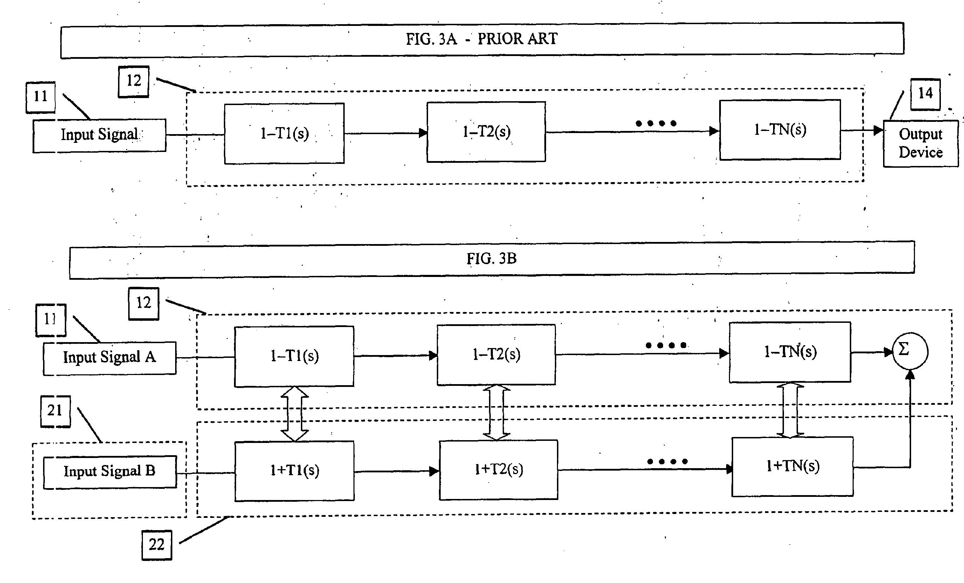

FIG. 3A is a general block diagram of a typical prior art multi-band audio equalizer, similar to FIG. 1, but with multiple eq type bands/sections (each of which may be identical, or with different or overlapping frequency ranges). These are connected in series, which produces the desired effect for these devices. The gain of each band's transfer function T may vary from above 0 to below 0, allowing both boost and cut.

FIG. 3B shows this scenario adapted for the addition of inverse filter elements, according to an embodiment of the present invention, where the secondary channel elements are eq type filters. Here also, the gain of each band's transfer function T may vary from -1 to +1, allowing both boost and cut. This arrangment introduces a definable error. Ideal operation maintains the gain relationship as indicated above; if both channels 12 and 22 receive the same input, $11=21= V_{in}$, the mixed output remains $2 \cdot V_{in}$ no matter what the EQ settings. With multiple EQ bands, the inputs to the second band pair are altered by the first band pair, and are no longer equivalent. As soon as there are two bands in series for both channels, with the channels then mixed together, the output transfer function,

$$In_A \cdot (1-T1(s)) \cdot (1-T2(s)) \ + \ In_B \cdot (1+T1(s)) \cdot (1+T2(s))$$

no longer reduces to $2 \cdot V_{in}$ when $In_A = In_B = V_{in}$, but becomes

$$(2 + 2 \cdot T1(s) \cdot T2(s)) \cdot V_{in}.$$

This error increases for each additional band. If all filters T1(s)...TN(s) are narrow bandpass filters with significantly different pole frequencies, the error can be kept to within $\pm 2$ dB across the spectrum. The error created by this series arrangement may be tolerable if independence of the inputs is to be maintained. Maintaining independence is useful in many circumstances, such as when manipulating a stereo pair. The separate set of controls 24 shown in FIG. 2B, allowing individual adjustments to the secondary channel parameters for each band, allow an operator to compensate for this error. Alternatively, the system may be configured as a graphic equalizer with fixed frequency and Q for each band, only varying the gains. A scenario such as this can be arranged to limit the multi-band error to a small tolerance.

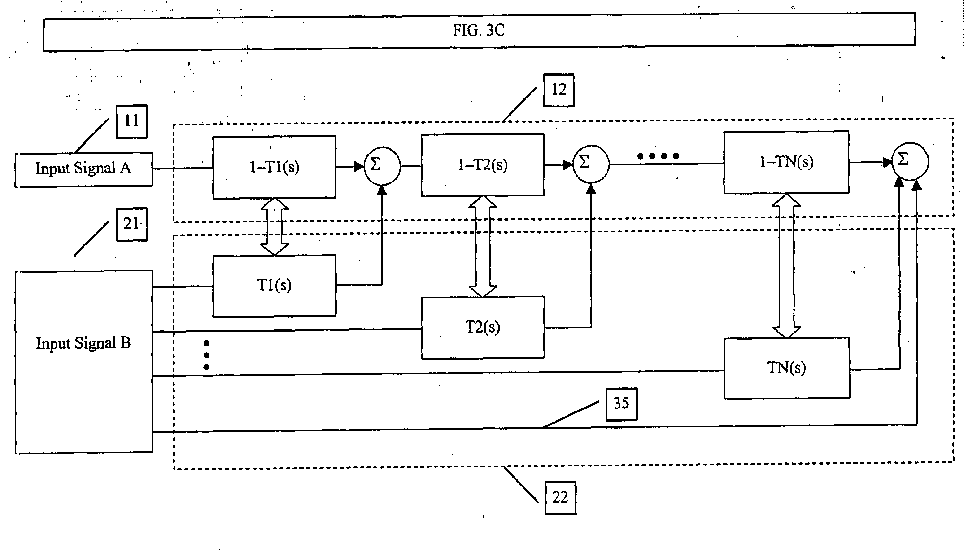

FIG. 3C shows an arrangement which reduces or eliminates this error. As above, the gain of each band's transfer function T may vary from -1 to +1, allowing both boost and cut, but all elements of secondary channel 22 must be of the simple filter type. Also changed here from FIG. 3B are the inputs and outputs of each band of secondary channel 22. Each band's secondary element receives its input directly from secondary input signal 21, and the output of each band's secondary element is supplied to the input of the next band's PRIMARY element. The output transfer function is

$$\{[\text{In}_A \cdot (1 - T1(s)) + \text{In}_B \cdot T1(s)] \cdot [1 - T2(s)] + \text{In}_B \cdot T2(s)\} ... \cdot ... (1 - TN(s)) + \text{In}_B \cdot TN(s) + \text{In}_B$$

With both inputs equal to $V_{in}$, the expression can be factored as:

$$V_{in} \cdot [\{[(1 - T1(s)) + T1(s)] \cdot [1 - T2(s)] + T2(s)\} ... \cdot ... (1 - TN(s)) + TN(s) + 1]$$

which reduces to $2V_{in}$. The addition of secondary channel input 21 to the final output, shown as line 35, is required for the simple filter elements of secondary channel 22 to operate with both boost and cut.

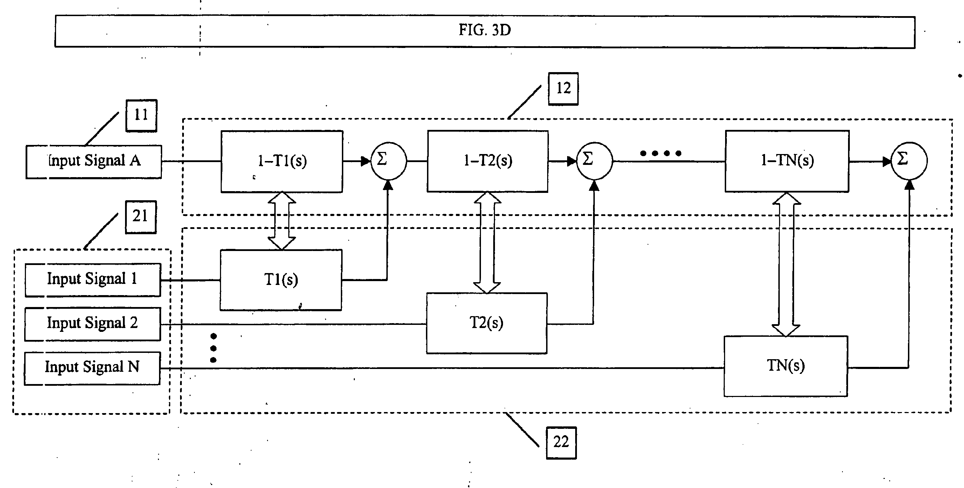

FIG. 3D is a general block diagram of an arrangement which avoids this error for a primary/secondary pair of channels with a multiplicity of bands 12/22 and a multiplicity of secondary inputs 21 (any or all of the secondary inputs 21 may be from a single source). All elements of secondary channel 22 should be of the simple filter type. The gain of each band's transfer function T may vary only from 0 to +1, allowing only cut in the primary channel filters. As in FIG. 3C, the filter functions are here incorporated at each step. There are no errors in maintaining gain relationships when all the inputs of 11 and 21 are equal, other than errors of construction tolerances. By mixing the outputs of each band pair and by using the mix as the input to the next band of the primary EQ, the multiple bands remain functionally independent from each other. As above, a filter is represented by $T(s)$, and an equalizer by $(1 - T(s))$. The final transfer function of the device is as follows:

$$\{[\text{In}_A \cdot (1 - T1(s)) + \text{In}_1 \cdot T1(s)] \cdot [1 - T2(s)] + \text{In}_2 \cdot T2(s)\} ... \cdot ... (1 - TN(s)) + \text{In}_N \cdot TN(s)$$

With all inputs equal to $V_{in}$, the expression can be factored as:

$$V_{in} \cdot [\{[(1 - T1(s)) + T1(s)] \cdot [1 - T2(s)] + T2(s)\} ... \cdot ... (1 - TN(s)) + TN(s)]$$

which equals $V_{in}$. The meaning of this equivalency is that there is a direct replacement of frequencies from one channel to another.

Rather than being fed to the succeeding primary channel filter inputs, the outputs of each secondary channel filter section of FIG. 3D may be summed separately to maintain channel independence, although accuracy is compromised. If all filters $T1(s) \sim TN(s)$ are narrow bandpass filters with significantly different pole frequencies, the error can be kept to within $\pm 2$ dB across the spectrum. The separate set of controls 24 shown in FIG. 2B, allowing individual adjustments to the secondary channel parameters for each band, allow an operator to compensate for this error.

The embodiments of Figures 3B and 3C are most appropriate where 2 useful signals are present, and one wants to affect certain frequency ranges of these two complementarily (boost one and cut the other). The embodiments of FIG. 3D are most appropriate when one wants to cut problematic frequency ranges of an otherwise useful signal, and 'fill them in' (replace them) with useful sections of an otherwise undesireable signal.

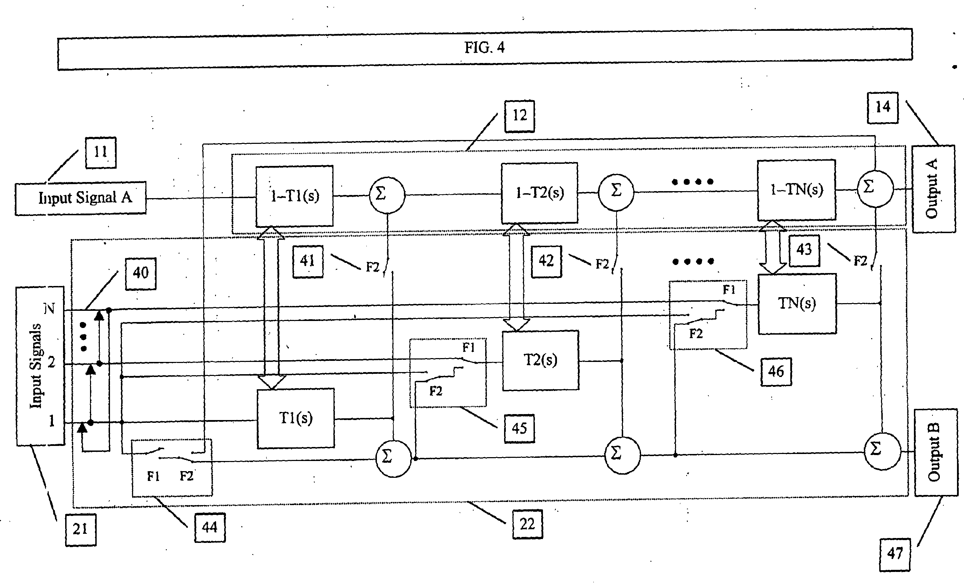

FIG. 4 is a general block diagram of an embodiment with a switching arrangement which allows a user to choose one of the embodiments of FIGS. 3A, 3B, 3C, and 3D from within a single device. Since the switching process is a straightforward implementation of the elements discussed above, a detailed descripton is not necessary here. Switch elements labeled the same (e.g., all switches marked F1) operate as a unit, and are toggled by a single user selection. The switching process must enable certain gain adjustments for proper operation.

The method suggests that exceptional benefits may be derived by constructing special devices for specific situations. One appropriate example arises when recording a drum set, where there are several sound sources in close proximity. It is common to record each element of the drum set (bass drum, snare drum, hi-hat cymbal pair, tom-toms, other cymbals, etc.) with a separate microphone and channel, so that the tone quality and relative volume levels may be adjusted as desired later. The sound of each instrument will be present, to some degree, in all the other instruments' microphones. This unwanted signal is called crosstalk.

A common problem is encountered when some frequencies above 1kHz from the hi-hat signal appear with great strength in the microphone placed above the snare drum, only a few inches from the hi-hat. The offending frequency spectrum can be equalized out of this signal, but, because those frequencies are an important part of the snare drum's sound, the resulting signal is defficient in the filtered region. This filtered signal from the microphone above the drum no longer has the problematic hi-hat crosstalk, but also has little of the high frequencies of the drum itself, which are very important for this instrument - what remains is a good representation of the drum's lower frequency range.

Placing a microphone underneath the snare drum reduces the crosstalk from the hi-hat significantly, because the drum itself is between the microphone and the offending hi-hat, and so acts as a sound barrier. But the sound underneath is a poor representation of the sound of the drum. Placement underneath misses the major contribution of the top drumhead's sound, caused partly by the sound of the contact by the drumstick which strikes it. Thus, the drum's low frequencies sound uncharacteristic below the drum, and it can be helpful to filter them out, leaving only the higher frequencies. Also, a significant portion of the snare drum signal's high frequency energy comes from the snares. These are usually metal springs which vibrate against the outside of the bottom head, underneath the drum. A microphone underneath the drum receives a disproportionate amount of this high frequency signal, compared to the normal sound of the drum. This filtered signal from a microphone below the drum is missing the problematic hi-hat crosstalk, but also has little of the drum's low frequencies - what remains is a good, but overly strong, representation of the drum's higher frequency range.

A summary of the results above is:

Signal from microphone above the drum, after hi frequencies are filtered out:

1- good low frequency drum signal
2- inadequate high frequency drum signal
3- low hi-hat crosstalk signal.

Signal from microphone below the drum after low frequencies are filtered out:

1- inadequate low frequency drum signal
2- good, but overly strong, high frequency drum signal
3- low hi-hat crosstalk signal.

Combining the results of the two filtered microphone signals results in a good full frequency representation of the snare drum, with a reduction in the crosstalk from the hi-hat. The signal from above the drum contributes only low frequencies, with no high frequency signal from either drum or hi-hat. The overly strong high frequency signal from below the drum requires that we use less of this signal in the combined signal, which advantageously further reduces the unwanted hi-hat crosstalk. Optimums for the difference in signal strength, and the shapes and poles of the filters, have been determined by experiment, and are given in the description which follows.

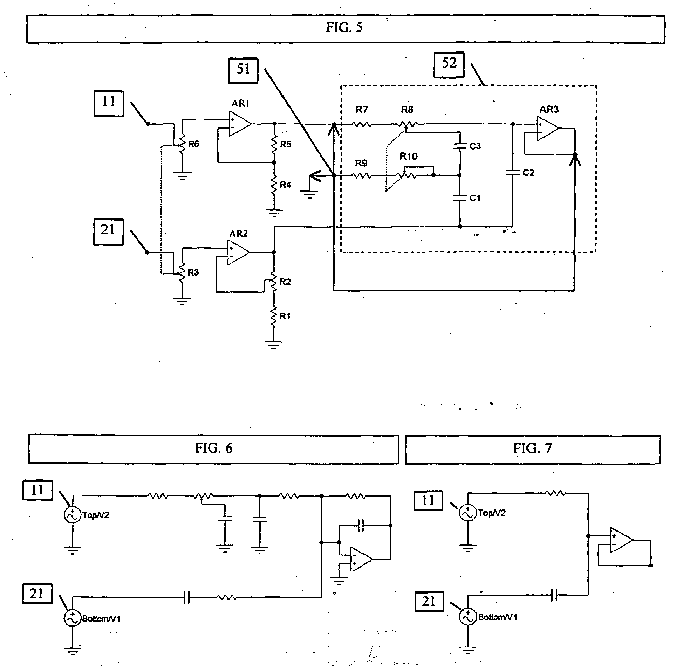

Referring to FIG. 5, the gain of microphone pre-amp AR2 (used for the microphone below the drum) is set to track about -9 dB lower than the the gain for pre-amp AR1 (used for the microphone above the drum). This assumes the use of microphones with equivalent sensitivity and signal level, each of the 2 microphones being placed about 1 inch from its appropriate drumhead. At this gain ratio, the resulting combined output sounds most similar to the acoustic sound when mixed at a majority of frequency settings determined by the dual potentiometer R8 + R10. The user can vary the level of bottom microphone 21's signal independently with variable resistor R2 to account for differences in microphones, snare timbre, placement, and taste. A single gain control, dual potentiometer R3 + R6, varies the pre-amp gain applied to both signals 11 (above drum microphone) and 21 (below drum microphone) in tandem. This maintains the set gain ratio, which allows the user to adjust level without worrying about the balance of the microphone signals.

The filter circuit 52 of FIG. 5 acts as a variable-frequency low pass for input signal 11 (from the microphone above the drum) and as a variable-frequency high pass for input signal 21 (from the microphone below the drum). At the highest frequency setting, the pole frequency for the low pass overlaps the pole frequency for the high pass by approximately one octave. Both poles are adjusted simultaneously with the single control (R8 + R10). As the pole frequencies are lowered, the overlap of the frequency poles drops to less than a third of an octave. In this example, the high pass responds as a first-order filter in parallel with a second-order filter. Also, in this example, the low pass filter is comprised of two first-order filters in series, with resonance. When the pole frequency is at its highest, the high-pass first-order function dominates, but the low pass is second order with matching poles. When the pole is lowest, the high-pass second-order function dominates, but the low pass is first order. Connection 51 can be to a) signal 11's pre-amp output, b) ground, or c) filter circuit 52's output, each yielding.a slightly different frequency response at the crossover frequencies. Scenarios a) and b) differ only in the top mic's resonance response, whereas c) adds resonance to both filter functions. Our experimentation shows that the approximate useful low-pass frequency range is 160 Hz to 8 kHz, and the approximate useful high-pass frequency range is 125 Hz to 4 kHz.

Figures 6 and 7 are simplified filter section versions of the example of FIG 5, where a cost savings can be attained in circumstances that will allow for it. In FIG. 6, input signal 11's low-pass frequency pole and filter slope vary as in FIG. 5, but the filter pole for the input signal 21 (from the microphone below the drum) is fixed at about 1 kHz. FIG. 7 is an even simpler version, with poles for both the low-pass and high-pass filters fixed at about 1kHz. They are shown here as first-order filter functions, but other filter orders can be easily constructed.

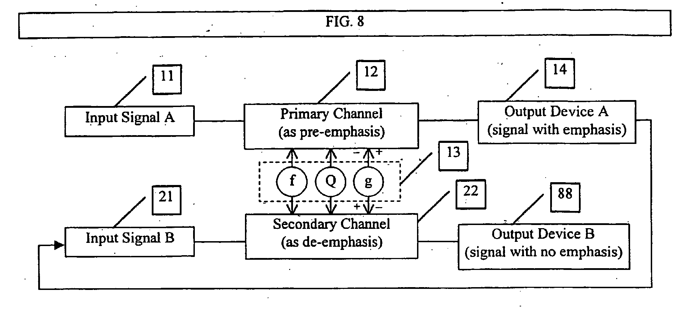

FIG. 8 shows an embodiment for another use of the present invention, as a variable emphasis/de-emphasis noise-reduction device. Primary Channel 12 adds emphasis by boosting a region, and Secondary Channel 22 de-emphasizes by cutting the same region. In this case, the gain relationships should be maintained not when summed, (i.e., mixed in parallel) but rather when multiplied (i.e., used in series); therefore output device 14 is inserted between 12 and 22 - the output of 14 becomes the Input Signal 21. To preserve unity gain from input to output, the total transfer function of 12 must be the reciprocal of the total transfer function of 22. The result is transparent for any linear function of processing implemented in the device/s 14. Since multiplication is associative, a multiplicity of bands can be used in series without any errors described in previous designs. Note that since the reciprocal of infinite cut is infinite boost, infinite cut is not possible.

Another specific application is for use with any acoustical instrument, such as the guitar. The guitar is commonly used with three common transducer types: air pressure microphones, accelerometer (physical vibration induction) pickups, and magnetic induction pickups. The most faithful reproduction is accomplished by the use of a high quality air pressure microphone. For truest fidelity, the microphone is placed at least as far from the instrument as the largest sound producing dimension of the instrument; for a guitar, this distance is between 0.5 and 1.0 meters. These microphones respond to all sound in the acoustic environment, creating problems with isolation and feedback (discussed below).

An accelerometer pickup induces energy from the physical vibrations of a particular part of the guitar's material body, usually the wood near the bridge (the energy from the strings is transmitted through the bridge to the rest of the instrument, so the vibrations are strongest there). The vibrations so induced are somewhat like the air-born sound waves which we normally hear, and the result, if done carefully, is a mediocre but recognizable instrument sound. These pickups do not suffer from isolation and feedback problems nearly as much as air pressure microphones.

A magnetic induction pickup requires the instrument to have metal strings, necessary to create the magnetic field which is then induced. The instrument is not required to (and most commonly does not) produce enough acoustic energy to be heard without the amplification for which it was designed, though it arose out of attempts to amplify pre-existing acoustic instruments. The sound produced only remotely resembles that produced by an instrument's body, but has given rise to what are essentially new instruments, such as the electric guitar, electric bass, and electric violin.

Acoustic guitars provide enough acoustic energy to be heard without assistance, but the amount of energy is small, and limits un-amplified use to a small range of circumstances. In the presence of a large space or other instruments, amplification is generally needed. When enough sound from the amplification system gets into the system source (the microphone or other transducer), a positive feedback loop is often created that drives the speaker amplifier into saturation, producing a loud howl. This is a common occurrence. The feedback generally occurs at specific frequency regions that are emphasized by accidental (random) circumstances of instrument construction, room construction, and placement of the instrument and transducer within the room and with relation to the amplification system. Air pressure devices are more sensitive to this problem than the other, lower fidelity induction devices. After optimizing for these circumstances, the common prior art corrective is to use a device such as an equalizer 12 (FIGS. 1, 3A) to reduce the level of the signal in the problematic frequency bands. This lowers the fidelity of the reduced signal, and a compromise must be reached.

A complimentary-pair equalizer according to an embodiment of the present invention may greatly improve the quality of sound in this circumstance. In one embodiment, a high-fidelity (e.g., air pressure microphone) signal is used as Primary Input Signal 11, and a lower fidelity (e.g., accelerometer 'pickup') signal is used as Secondary Input Signal 21. An appropriate embodiment may be used, such as one of those in the FIGS. 2A, 2B, 3B, 3C, or 3D. In the prior art, frequency bands which include feedback in the acoustic microphone are merely reduced. The present invention not only reduces these bands from the (primary) acoustic microphone signal, but replaces them with the (secondary) accelerometer signal from the same bands. This may provide a higher fidelity overall signal quality than that from the accelerometer alone, and may also greatly increase the gain-before-feedback level available with only an air pressure microphone.

Although embodiments are specifically illustrated and described herein, it will be appreciated that modifications and variations of the present invention are covered by the above teachings and within the purview of the appended claims without departing from the scope of the invention. For example, though many of the circuits described above are designed for use with analog signals, one skilled in the art, given the teachings above, will appreciate that these circuits may be modified to handle digital signals as well.

**Claims**

1. A method of processing signals comprising:

   Providing a first signal (11) and a second signal (21), said first signal (11) and second signal (21) being supplied by first and second transducers which produce first and second signals (11,21) generated by a source through different positions of the transducers relative to the source or through the transduction of different energy medium types, each of said first and second signals (11,21) comprising a frequency spectrum including a plurality of frequency bands, such that the second signal 21 has an increase in ratio of a desired sound to an undesired sound in a frequency range as compared to the first signal (11) in the same frequency range;
   Supplying said first and second signals (11,21) to first and second signal processors (12, 22) respectively;
   Selecting at least one of said plurality of frequency bands comprising said undesired sound with said first signal processor (12) and selecting at least one of said plurality of frequency bands with said second signal processor (22), wherein said selections are less than the frequency spectrum of the plurality of frequency bands for said first and second signals;
   Adjusting a level for the at least one frequency band selected by said first processor (12) with said first processor, and adjusting a level for the at least one frequency band selected by said second processor (22) with said second processor, such that an increase in level of said selected at least one frequency band in one of said first and second signals results in a decrease in level of said selected at least one frequency band in the other of said first and second signals, and said increase in level and said resultant decrease in level are performed independently of changes to other frequency bands in said first and second signal processors: and
   Summing 23 said adjusted and the other frequency bands of the first signal (11) and said adjusted and the other frequency bands of the second signal (21).

2. The method of claim 1 wherein a magnitude of said increase in level is equal to a magnitude of said decrease in level.

3. The method of claim 1 or 2 further comprising:

   Adjusting the level of the first and second signals prior to providing said first and second signals to said signal (11,21) processors.

4. The method of claim 1, 2, or 3 further comprising:

   Separately adjusting said selected frequency bands for the first and second signals (11,21).

5. The method of any of claims 1 to 4 wherein said first and second signals (11,21) are supplied to first and second groups of signal processors, and said adjustment step is made with first and second groups of signal processors.

6. The method of claim 5 wherein in said supplying step, said first group of signal processors are coupled in series and said second group of signal processors are coupled in parallel, and in said combining step, corresponding outputs of signal processors from said first and second groups of processors are summed individually.

7. The method of claim 6 wherein in said combining step an unaltered alternate signal is combined with said first and alternate signals after said adjusting step.

8. The method of any of claims 1 to 7 wherein said first and second signals (11,21) are derived from first and second positions relative to an instrument, respectively

9. The method of claim 8 wherein said instrument is a snare drum and said first location is above said snare drum and said second location is below said snare drum.

10. The method of claim 9 wherein in said adjusting step, a preset ratio of a gain for the second signal (21) is between 11 and 5 dB lower than said gain for said first signal (11).

11. The method of claim 8 wherein one of said first and second signal processors is a high-pass filter and the other of said first and second signal processors is a low pass-filter.

12. The method of claim 11 where a pole for each of said filters is set at 1 kHz.

13. The method of claim 11 where a pole of the high-pass filter is set at 1 kHz, and a pole of the low-pass filter is variable between a first order low-pass at approximately 160 Hz and a second order low-pass at approximately 8 kHz.

14. The method of claim 11 further comprising:

   Adjusting a pole for each of said high-pass and low-pass filters.

15. The method of claim 11 where at high frequency poles said high-pass and low-pass filters overlap approximately one octave and at low frequency poles said high-pass and low-pass filter overlap approximately one-third of an octave.

16. The method of claim 14 where an approximate adjustment range of the high-pass filter frequency pole is between 160 Hz and 8 kHz, in conjunction with an approximate adjustment range of the low-pass filter being between 125 Hz to 4 kHz.

17. An apparatus for processing signals comprising:

   a first input to receive a first signal (11) and a second input to receive a second signal (21) said first signal (11) and second signal (21) being supplied by first and second transducers generated by a source through different positions of the transducers relative to the source, each of said first and second signals comprising a frequency spectrum including a plurality of frequency bands, such that the second signal (21) has an increase in ratio of a desired sound to an undesired sound in a frequency range as compared to the first signal 11 in the same frequency range;
   first and second signal processors (12,22) adapted to receive said first and second signals, respectively;
   said first signal processor (12) further adapted to select at least one of said plurality of frequency bands comprising said undesired sound, wherein said selection is less than the frequency spectrum of the plurality of frequency bands for said first signal (11);
   said second signal processor (22) further adapted to select at least one of said plurality of frequency bands comprising said undesired sound, wherein said selection is less than the frequency spectrum of the plurality of frequency bands for said second signal (21) ;
   the first signal processor (12) further adapted to adjust a level for the at least one frequency band selected by said first processor (12), and said second signal processor (22) further adapted to adjust a level for the at least one frequency band selected by said second processor (22) such that an increase in level of said selected at least one frequency band in one of said first and second signals (11,21) results in a decrease in level of said selected at least one frequency band in the other of said first and second signals (11,21), and said increase in level and said resultant decrease in level are performed independently of changes to other frequency bands in said first and second signal processors (12,22), and
   a circuit 23 to sum said adjusted and the other frequency bands of the first signal (11) and said adjusted and the other frequency band of the second signal (22).

18. The apparatus of claim 17 wherein a magnitude of said increase in level is equal to a magnitude of said decrease in level.

19. The apparatus of claim 17 or 18 wherein said selected frequency bands are separately adjusted for the first and second signals (11,21).

20. The apparatus of claim 17, 18, or 19 wherein said first and second signals (11,21) are supplied to first and second groups of signal processors, and said adjustment step is made with respective first and second groups of signal processors.

21. The apparatus of claim 20 wherein said first group of signal processors are coupled in series and said second group of signal processors are coupled in parallel, and corresponding outputs of signal processors from said first and second groups of processors are summed individually.

22. The apparatus of any of claims 17 to 21 wherein said first and second signals (11,21) are derived from first and second positions relative to an instrument, respectively.

23. The apparatus of claim 22 wherein said instrument is a snare drum and said first location is above said snare drum and said second location is below said snare drum.

24. The apparatus of claim 22 wherein one of said first and second signal processors is a high-pass filter and the other of said first and second signal processors is a low pass-filter.

25. The apparatus of claim 24 where at high frequency poles said high-pass and low-pass filters overlap approximately one octave and at low frequency poles said high-pass and low-pass filters overlap approximately one-third of an octave.

26. The apparatus of claim 22 wherein said first signal source includes an acoustic pressure microphone and said second signal source includes an accelerometer pickup.

27. The apparatus of claim 22 wherein said first signal source includes an acoustic pressure microphone and said second signal source includes an electromagnetic pickup.

28. The apparatus of claim 17 wherein said first and second signal sources are from a guitar

29. The apparatus of claim 28 wherein said first signal source includes an acoustic pressure microphone and said alternate signal source includes an accelerometer pickup.

30. The apparatus of claim 28 wherein said first signal source includes an acoustic pressure microphone and said alternate signal source includes an electromagnetic pickup.

31. The method of claim 1 wherein said selections are the same in both of said first and second signal processors.

32. The apparatus of any of claims 17 to 30 wherein said at least one of said plurality of frequency bands selected by said first and second processors are the same.

33. The apparatus of any of claims 17 to 30 further comprising a mixer to combine said first and second signals.

34. The apparatus of claim 18, wherein means are provided for separately adjusting the level of the first and second signals (11,21) prior to providing said first and second signals to said signal processors.


**Patentansprüche**

1. Verfahren zur Verarbeitung von Signalen mit:

Bereitstellen eines ersten Signals (11) und eines zweiten Signals (21), wobei das erste Signal (11) und zweite Signal (21) durch einen ersten und einen zweiten Wandler zugeführt werden, die ein erstes und zweites Signal (11, 21) produzieren, die durch eine Quelle über unterschiedliche Positionen der Wandler relativ zur Quelle oder über die Fortleitung unterschiedlicher Energiemedienarten erzeugt werden, wobei das erste und zweite Signal (11, 21) jeweils ein Frequenzspektrum mit mehreren Frequenzbändern so aufweisen, daß das zweite Signal (21) eine Zunahme des Verhältnisses eines erwünschten Klangs zu einem unerwünschten Klang in einem Frequenzbereich verglichen mit dem ersten Signal (11) im gleichen Frequenzbereich hat;
Zuführen des ersten und zweiten Signals (11, 21) zu einem ersten bzw. einem zweiten Signalprozessor (12, 22);
Auswählen mindestens eines der mehreren Frequenzbänder, das den unerwünschten Klang aufweist, mit dem ersten Signalprozessor (12) und Auswählen mindestens eines der mehreren Frequenzbänder mit dem zweiten Signalprozessor (22), wobei die Auswahlen kleiner als das Frequenzspektrum der mehreren Frequenzbänder für das erste und zweite Signal sind;

Einstellen eines Pegels für das durch den ersten Prozessor (12) ausgewählte mindestens eine Frequenzband mit dem ersten Prozessor und Einstellen eines Pegels für das durch den zweiten Prozessor (22) ausgewählte mindestens eine Frequenzband mit dem zweiten Prozessor, so daß eine Pegelzunahme des ausgewählten mindestens einen Frequenzbands in dem ersten oder zweiten Signal zu einer Pegelabnahme des ausgewählten mindestens einen Frequenzbands in dem anderen aus dem ersten und zweiten Signal führt und die Pegelzunahme sowie die resultierende Pegelabnahme unabhängig von Änderungen an anderen Frequenzbändern im ersten und zweiten Signalprozessor durchgeführt werden; und

Summieren (23) des eingestellten und der anderen Frequenzbänder des ersten Signals (11) sowie des eingestellten und der anderen Frequenzbänder des zweiten Signals (21).

2. Verfahren nach Anspruch 1, wobei eine Größe der Pegelzunahme gleich einer Größe der Pegelabnahme ist.

3. Verfahren nach Anspruch 1 oder 2, ferner mit:

   Einstellen des Pegels des ersten und zweiten Signals vor Zuführen des ersten und zweiten Signals zu den Signal-(11, 21) Prozessoren.

4. Verfahren nach Anspruch 1, 2 oder 3, ferner mit:

   getrenntes Einstellen der ausgewählten Frequenzbänder für das erste und zweite Signal (11, 21).

5. Verfahren nach einem der Ansprüche 1 bis 4, wobei das erste und zweite Signal (11, 21) einer ersten und einer zweiten Gruppe von Signalprozessoren zugeführt werden und der Einstellschritt mit der ersten und zweiten Gruppe von Signalprozessoren vorgenommen wird.

6. Verfahren nach Anspruch 5, wobei im Zufuhrschritt die erste Gruppe von Signalprozessoren in Reihe gekoppelt ist und die zweite Gruppe von Signalprozessoren parallel gekoppelt ist und im Kombinierschritt entsprechende Ausgaben von Signalprozessoren aus der ersten und zweiten Gruppe von Prozessoren individuell summiert werden.

7. Verfahren nach Anspruch 6, wobei im Kombinierschritt ein unverändertes alternatives Signal mit dem ersten und alternativen Signal nach dem Einstellschritt kombiniert wird.

8. Verfahren nach einem der Ansprüche 1 bis 7, wobei das erste und zweite Signal (11, 21) von einer ersten bzw. einer zweiten Position relativ zu einem Instrument abgeleitet werden.

9. Verfahren nach Anspruch 8, wobei das Instrument eine kleine Trommel ist und die erste Stelle über der kleinen Trommel und die zweite Stelle unter der kleinen Trommel liegt.

10. Verfahren nach Anspruch 9, wobei im Einstellschritt ein voreingestelltes Verhältnis einer Verstärkung für das zweite Signal (21) zwischen 11 und 5 dB niedriger als die Verstärkung für das erste Signal (11) ist.

11. Verfahren nach Anspruch 8, wobei der erste oder der zweite Signalprozessor ein Hochpaßfilter und der andere aus dem ersten und zweiten Signalprozessor ein Tiefpaßfilter ist.

12. Verfahren nach Anspruch 11, wobei ein Pol für jedes der Filter auf 1 kHz eingestellt ist.

13. Verfahren nach Anspruch 11, wobei ein Pol des Hochpaßfilters auf 1 kHz eingestellt ist und ein Pol des Tiefpaßfilters zwischen einem Tiefpaß erster Ordnung mit etwa 160 Hz und einem Tiefpaß zweiter Ordnung mit etwa 8 kHz variabel ist.

14. Verfahren nach Anspruch 11, ferner mit:

    Einstellen eines Pols für das jeweilige Hochpaß- und Tiefpaßfilter.

15. Verfahren nach Anspruch 11, wobei sich an Hochfrequenzpolen das Hochpaß- und Tiefpaßfilter etwa eine Oktave überschneiden und sich an Niederfrequenzpolen das Hochpaß- und Tiefpaßfilter etwa ein Drittel einer Oktave überschneiden.

**16.** Verfahren nach Anspruch 14, wobei ein annähernder Einstellbereich des Frequenzpols des Hochpaßfilters zwischen 160 Hz und 8 kHz in Verbindung mit einem annähernden Einstellbereich des Tiefpaßfilters liegt, der zwischen 125 Hz bis 4 kHz liegt.

**17.** Vorrichtung zur Verarbeitung von Signalen mit:

einem ersten Eingang, um ein erstes Signal (11) zu empfangen, und einem zweiten Eingang, um ein zweites Signal (21) zu empfangen, wobei das erste Signal (11) und zweite Signal (21) durch einen ersten und einen zweiten Wandler zugeführt werden, durch eine Quelle über unterschiedliche Positionen der Wandler relativ zur Quelle erzeugt werden, wobei das erste und zweite Signal jeweils ein Frequenzspektrum mit mehreren Frequenzbändern so aufweisen, daß das zweite Signal (21) eine Zunahme des Verhältnisses eines erwünschten Klangs zu einem unerwünschten Klang in einem Frequenzbereich verglichen mit dem ersten Signal (11) im gleichen Frequenzbereich hat;
einem ersten und einem zweiten Signalprozessor (12, 22), die ausgebildet sind, das erste bzw. zweite Signal zu empfangen;

wobei der erste Signalprozessor (12) ferner ausgebildet ist, mindestens eines der mehreren Frequenzbänder mit dem unerwünschten Klang auszuwählen, wobei die Auswahl kleiner als das Frequenzspektrum der mehreren Frequenzbänder für das erste Signal (11) ist;
wobei der zweite Signalprozessor (22) ferner ausgebildet ist, mindestens eines der mehreren Frequenzbänder mit dem unerwünschten Klang auszuwählen, wobei die Auswahl kleiner als das Frequenzspektrum der mehreren Frequenzbänder für das zweite Signal (21) ist;
wobei der erste Signalprozessor (12) ferner ausgebildet ist, einen Pegel für das durch den ersten Prozessor (12) ausgewählte mindestens eine Frequenzband einzustellen, und der zweite Signalprozessor (22) ferner ausgebildet ist, einen Pegel für das durch den zweiten Prozessor (22) ausgewählte mindestens eine Frequenzband einzustellen, so daß eine Pegelzunahme des ausgewählten mindestens einen Frequenzbands in dem ersten oder zweiten Signal (11, 21) zu einer Pegelabnahme des ausgewählten mindestens einen Frequenzbands in dem anderen aus dem ersten und zweiten Signal (11, 21) führt und die Pegelzunahme sowie die resultierende Pegelabnahme unabhängig von Änderungen an anderen Frequenzbändern im ersten und zweiten Signalprozessor (12, 22) durchgeführt werden; und
einer Schaltung (23), um das eingestellte und die anderen Frequenzbänder des ersten Signals (11) sowie das eingestellte und die anderen Frequenzbänder des zweiten Signals (21) zu summieren.

**18.** Vorrichtung nach Anspruch 17, wobei eine Größe der Pegelzunahme gleich einer Größe der Pegelabnahme ist.

**19.** Vorrichtung nach Anspruch 17 oder 18, wobei die ausgewählten Frequenzbänder für das erste und zweite Signal (11, 21) getrennt eingestellt werden.

**20.** Vorrichtung nach Anspruch 17, 18 oder 19, wobei das erste und zweite Signal (11, 21) einer ersten und einer zweiten Gruppe von Signalprozessoren zugeführt werden und der Einstellschritt mit einer jeweiligen ersten und zweiten Gruppe von Signalprozessoren vorgenommen wird.

**21.** Vorrichtung nach Anspruch 20, wobei die erste Gruppe von Signalprozessoren in Reihe gekoppelt ist und die zweite Gruppe von Signalprozessoren parallel gekoppelt ist und entsprechende Ausgaben von Signalprozessoren aus der ersten und zweiten Gruppe von Prozessoren individuell summiert werden.

**22.** Vorrichtung nach einem der Ansprüche 17 bis 21, wobei das erste und zweite Signal (11, 21) von einer ersten bzw. einer zweiten Position relativ zu einem Instrument abgeleitet sind.

**23.** Vorrichtung nach Anspruch 22, wobei das Instrument eine kleine Trommel ist und die erste Stelle über der kleinen Trommel und die zweite Stelle unter der kleinen Trommel liegt.

**24.** Vorrichtung nach Anspruch 22, wobei der erste oder zweite Signalprozessor ein Hochpaßfilter und der andere aus dem ersten und zweiten Signalprozessor ein Tiefpaßfilter ist.

**25.** Vorrichtung nach Anspruch 24, wobei sich an Hochfrequenzpolen das Hochpaß- und Tiefpaßfilter etwa eine Oktave überschneiden und sich an Niederfrequenzpolen das Hochpaß- und Tiefpaßfilter etwa ein Drittel einer Oktave überschneiden.

**26.** Vorrichtung nach Anspruch 22, wobei die erste Signalquelle ein akustisches Druckmikrofon aufweist und die zweite Signalquelle einen Beschleunigungsaufnehmer aufweist.

**27.** Vorrichtung nach Anspruch 22, wobei die erste Signalquelle ein akustisches Druckmikrofon aufweist und die zweite Signalquelle einen elektromagnetischen Aufnehmer aufweist.

**28.** Vorrichtung nach Anspruch 17, wobei die erste und zweite Signalquelle von einer Gitarre stammen.

**29.** Vorrichtung nach Anspruch 28, wobei die erste Signalquelle ein akustisches Druckmikrofon aufweist und die alternative Signalquelle einen Beschleunigungsaufnehmer aufweist.

**30.** Vorrichtung nach Anspruch 28, wobei die erste Signalquelle ein akustisches Druckmikrofon aufweist und die alternative Signalquelle einen elektromagnetischen Aufnehmer aufweist.

**31.** Verfahren nach Anspruch 1, wobei die Auswahlen sowohl im ersten als auch im zweiten Signalprozessor gleich sind.

**32.** Vorrichtung nach einem der Ansprüche 17 bis 30, wobei das mindestens eine der durch den ersten und zweiten Prozessor ausgewählten mehreren Frequenzbänder gleich ist.

**33.** Vorrichtung nach einem der Ansprüche 17 bis 30, ferner mit einem Mischer, um das erste und zweite Signal zu kombinieren.

**34.** Vorrichtung nach Anspruch 18, wobei Einrichtungen zum getrennten Einstellen des Pegels des ersten und zweiten Signals (11, 21) vor Zuführen des ersten und zweiten Signals zu den Signalprozessoren vorgesehen sind.

**Revendications**

**1.** Procédé de traitement de signaux comprenant les étapes consistant à :

fournir un premier signal (11) et un second signal (21), ledit premier signal (11) et ledit second signal (21) étant délivrés par des premier et second transducteurs qui produisent des premier et second signaux (11, 21) générés par une source via différentes positions des transducteurs par rapport à la source ou via la transduction de différents types de supports d'énergie, chacun desdits premier et second signaux (11, 21) comprenant un spectre de fréquences comprenant une pluralité de bandes de fréquences, de sorte que le second signal (21) ait une augmentation du rapport du son souhaité au son non souhaité dans une plage de fréquences en comparaison du premier signal (11) dans la même plage de fréquences ;
délivrer lesdits premier et second signaux (11, 21) à des premier et second dispositifs de traitement de signaux (12, 22), respectivement ;
sélectionner au moins une bande de ladite pluralité de bandes de fréquences, comprenant ledit son non souhaité avec ledit premier dispositif de traitement de signal (12) et sélectionner au moins une bande de ladite pluralité de bandes de fréquences avec ledit second dispositif de traitement de signal (22), lesdites sélections étant moindres que le spectre de fréquences de la pluralité de bandes de fréquences pour lesdits premier et second signaux ;
ajuster un niveau pour la au moins une bande de fréquences sélectionnée par ledit premier dispositif de traitement (12) avec ledit premier dispositif de traitement et ajuster un niveau pour la au moins une bande de fréquences sélectionnée par ledit second dispositif de traitement (22) avec ledit second dispositif de traitement de sorte qu'une augmentation de niveau de ladite au moins une bande de fréquences sélectionnée dans l'un desdits premier et second signaux entraîne une diminution de niveau de ladite au moins une bande de fréquence sélectionnée dans l'autre desdits premier et second signaux; et que ladite augmentation de niveau et ladite diminution de niveau obtenue soient réalisées indépendamment de changements dans d'autres bandes de fréquences desdits premier et second dispositifs de traitement de signaux ; et
sommer (23) lesdites bandes de fréquences ajustées et les autres bandes de fréquences du premier signal (11) et lesdites bandes de fréquences ajustées et les autres bandes de fréquences du second signal (21).

**2.** Procédé selon la revendication 1, dans lequel une grandeur de ladite augmentation de niveau est égale à une grandeur de ladite diminution de niveau.

**3.** Procédé selon la revendication 1 ou 2, comprenant en outre l'étape consistant à :

ajuster le niveau des premier et second signaux avant de fournir lesdits premier et second signaux auxdits dispositifs de traitement de signaux (11, 21).

**4.** Procédé selon la revendication 1, 2 ou 3 comprenant en outre l'étape consistant à :

ajuster séparément lesdites bandes de fréquences sélectionnées pour les premier et second signaux (11, 21).

**5.** Procédé selon l'une quelconque des revendications 1 à 4, dans lequel lesdits premier et second signaux (11, 21) sont délivrés à des premier et second groupes de dispositifs de traitement de signaux et ladite étape d'ajustement est réalisée avec des premier et seconds groupes de dispositifs de traitement de signaux.

**6.** Procédé selon la revendication 5, dans lequel, à ladite étape de délivrance, ledit premier groupe de dispositifs de traitement de signaux est couplé en série et ledit second groupe de dispositifs de traitement de signaux est couplé en parallèle et à ladite étape de combinaison, des sorties correspondantes de dispositifs de traitement de signaux desdits premier et second groupes de dispositifs de traitement sont sommées individuellement.

**7.** Procédé selon la revendication 6, dans lequel, à ladite étape de combinaison, un signal alternatif non altéré est combiné auxdits premier signal et signal alterné après ladite étape d'ajustement.

**8.** Procédé selon l'une quelconque des revendications 1 à 7, dans lequel lesdits premier et second signaux (11, 21) sont dérivés des première et seconde positions par rapport à un instrument, respectivement.

**9.** Procédé selon la revendication 8, dans lequel ledit instrument est une caisse claire et ledit premier emplacement se situe au-dessus de ladite caisse claire et ledit second emplacement se situe en dessous de ladite caisse claire.

**10.** Procédé selon la revendication 9, dans lequel, à ladite étape d'ajustement, un rapport préétabli d'un gain pour le second signal (21) se situe entre 11 et 5 dB en dessous de celui dudit gain pour ledit premier signal (11).

**11.** Procédé selon la revendication 8, dans lequel un desdits premier et second dispositifs de traitement de signaux est un filtre passe-haut et l'autre desdits premier et second dispositifs de traitement de signaux est un filtre passe-bas.

**12.** Procédé selon la revendication 11, dans lequel un pôle pour chacun desdits filtres est réglé à 1 kHz.

**13.** Procédé selon la revendication 11, dans lequel un pôle du filtre passe-haut est réglé à 1 kHz et un pôle du filtre passe-bas est variable entre un passe-bas de premier ordre à environ 160 Hz et un passe-bas de second ordre à environ 8 kHz.

**14.** Procédé selon la revendication 11, comprenant en outre l'étape consistant à :

ajuster un pôle à chacun desdits filtres passe-haut et passe-bas.

**15.** Procédé selon la revendication 11, dans lequel aux pôles de hautes fréquences, lesdits filtres passe-haut et passe-bas se chevauchent sur environ une octave et, aux pôles de basses fréquences, lesdits filtres passe-haut et passe-bas se chevauchent d'environ un tiers d'octave.

**16.** Procédé selon la revendication 14, dans lequel une plage d'ajustement approximative du pôle de fréquences du filtre passe-haut se situe entre 160 Hz et 8 kHz, conjointement avec une plage d'ajustement approximative du filtre passe-bas entre 125 Hz et 4 kHz.

**17.** Appareil pour traiter des signaux comprenant :

une première entrée pour recevoir un premier signal (11) et une seconde entrée pour recevoir un second signal (21), ledit premier signal (11) et ledit second signal (21) étant délivrés par des premier et second transducteurs et générés par une source via différentes positions des transducteurs par rapport à la source, chacun desdits premier et second signaux comprenant un spectre de fréquences comprenant une pluralité de bandes de fréquences, de sorte que le second signal (21) ait une augmentation du rapport d'un son souhaité à un son non souhaité dans une plage de fréquences en comparaison du premier signal (11) dans la même plage de fréquences ;

des premier et second dispositifs de traitement de signaux (12, 22) adaptés pour recevoir lesdits premier et second signaux, respectivement ;

ledit premier dispositif de traitement de signaux (12) étant adapté en outre pour sélectionner au moins une de ladite pluralité de bandes de fréquences comprenant ledit son non souhaité, ladite sélection étant inférieure au spectre de fréquences de la pluralité de bandes de fréquences pour ledit premier signal (11) ;

ledit second dispositif de traitement de signaux (22) étant en outre adapté pour sélectionner au moins une de ladite pluralité de bandes de fréquences comprenant ledit son non souhaité, ladite sélection étant inférieure au spectre de fréquences de la pluralité de bandes de fréquences pour ledit second signal (21) ;

le premier dispositif de traitement de signaux (12) étant en outre adapté pour ajuster un niveau pour la au moins une bande de fréquences sélectionnée par ledit premier dispositif de traitement (12), et ledit second dispositif de traitement de signaux (22) étant en outre adapté pour ajuster un niveau pour la au moins une bande de fréquences sélectionnée par ledit second dispositif de traitement (22) de sorte qu'une augmentation du niveau de ladite au moins une bande de fréquences sélectionnée dans un desdits premier et second signaux (11, 21) entraîne une diminution du niveau de ladite au moins une bande de fréquences sélectionnée dans l'autre desdits premier et second signaux (11, 21) ; et ladite augmentation de niveau et ladite diminution de niveau obtenue sont réalisées indépendamment de changements à d'autres bandes de fréquence dans lesdits premier et second dispositifs de traitement de signaux (12, 22) ; et

un circuit (23) pour sommer lesdites bandes de fréquences ajustées et les autres bandes de fréquences du premier signal (11) et lesdites bandes de fréquences ajustées et les autres bandes de fréquences du second signal (21).

18. Appareil selon la revendication 17, dans lequel une grandeur de ladite augmentation de niveau est égale à une grandeur de ladite diminution de niveau.

19. Appareil selon la revendication 17 ou 18, dans lequel lesdites bandes de fréquences sélectionnées sont ajustées séparément pour les premier et second signaux (11, 21).

20. Appareil selon la revendication 17, 18 ou 19, dans lequel lesdits premier et second signaux (11, 21) sont délivrés aux premier et second groupes de dispositifs de traitement de signaux et ladite étape d'ajustement est effectuée avec des premier et second groupes respectifs de dispositifs de traitement de signaux.

21. Appareil selon la revendication 20, dans lequel ledit premier groupe de dispositifs de traitement de signaux est couplé en série et ledit second groupe de dispositifs de traitement de signaux est couplé en parallèle et des sorties correspondantes de dispositifs de traitement de signaux desdits premier et second groupes de dispositifs de traitement sont sommées individuellement.

22. Appareil selon l'une quelconque des revendications 17 à 21, dans lequel lesdits premier et second signaux (11, 21) sont dérivés des première et seconde positions relatives à un instrument, respectivement.

23. Appareil selon la revendication 22, dans lequel ledit instrument est une caisse claire et ledit premier emplacement se situe au-dessus de ladite caisse claire et ledit second emplacement se situe en dessous de ladite caisse claire.

24. Appareil selon la revendication 22, dans lequel un desdits premier et second dispositifs de traitement de signaux est un filtre passe-haut et l'autre desdits premier et second dispositifs de traitement de signaux est un filtre passe-bas.

25. Appareil selon la revendication 24, dans lequel, aux pôles de fréquences élevées, lesdits filtres passe-haut et passe-bas se chevauchent sur environ une octave et, aux pôles de basses fréquences, lesdites filtres passe-haut et passe-bas se chevauchent sur environ un tiers d'octave.

26. Appareil selon la revendication 22, dans lequel ladite premier source de signal comprend un microphone à pression acoustique et ladite seconde source de signal comprend un capteur de type accéléromètre.

27. Appareil selon la revendication 22, dans lequel ladite première source de signal comprend un microphone à pression acoustique et ladite seconde source de signal comprend un capteur électromagnétique.

28. Appareil selon la revendication 17, dans lequel lesdites première et seconde sources de signaux proviennent d'une guitare.

29. Appareil selon la revendication 28, dans lequel ladite première source de signal comprend un microphone à pression acoustique et ladite autre source de signal comprend un capteur de type accéléromètre.

30. Appareil selon la revendication 28, dans lequel ladite première source de signal comprend un microphone à pression acoustique et ladite autre source de signal comprend un capteur électromagnétique.

31. Procédé selon la revendication 1, dans lequel lesdites sélections sont les mêmes dans les deux dits premier et second dispositifs de traitement de signaux.

32. Appareil selon l'une quelconque des revendications 17 à 30, dans lequel ladite au moins une de ladite pluralité de bandes de fréquences sélectionnées par lesdits premier et second dispositifs de traitement est la même.

33. Appareil selon l'une quelconque des revendications 17 à 30, comprenant en outre un mixeur pour combiner lesdits premier et second signaux.

34. Appareil selon la revendication 18, dans lequel des moyens sont fournis pour ajuster séparément le niveau des premier et second signaux (11, 21) avant de délivrer lesdits premier et second signaux auxdits dispositifs de traitement de signaux.

**EP 1 786 236 B1**

FIG. 1 - PRIOR ART

FIG. 2A

FIG. 2B

FIG. 3A - PRIOR ART

| 11 | 12 | | | | 14 |

Input Signal → 1–T1(s) → 1–T2(s) → • • • • → 1–TN(s) → Output Device

FIG. 3B

Input Signal A → 1–T1(s) → 1–T2(s) → • • • • → 1–TN(s) → Σ

Input Signal B → 1+T1(s) → 1+T2(s) → • • • • → 1+TN(s)

EP 1 786 236 B1

18

FIG. 3C

FIG.3D

FIG. 4

Input Signal A

Output A

Output B

Input Signals

N
2
1

1-T1(s)   Σ   1-T2(s)   Σ   • • • •   1-TN(s)   Σ

T1(s)

T2(s)

TN(s)

F1   F2

F1
F2

F1
F2

F1
F2

Σ   Σ   Σ

11   12   14   40   41   42   43   44   45   46   47   21   22

EP 1 786 236 B1

21

FIG. 5

51

52

11

AR1

R6

R5

R4

R7    R8

R9    R10

C3

C1

C2

AR3

21

AR2

R3

R2

R1

FIG. 6

11

Top/V2

21

Bottom/V1

FIG. 7

11

Top/V2

21

Bottom/V1

FIG. 8

| | 11 | | | 12 | | | 14 |

Input Signal A → Primary Channel (as pre-emphasis) → Output Device A (signal with emphasis)

13

( f ) ( Q ) ( g )   − ∧ +

| 21 | | | 22 | | 88 |

Input Signal B → Secondary Channel (as de-emphasis) → Output Device B (signal with no emphasis)

+ ∨ −

FIG. 9

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5748754 A